# EUROPEAN PATENT APPLICATION

(11) **EP 3 190 701 A1**
(43) Date of publication of application: **12.07.2017**
(21) Application number: 16290006.2
(22) Date of filing: 07.01.2016
(51) Int. Cl.: H03G 3/30

(54) **VARIABLE GAIN AMPLIFIER WITH PROGRAMMABLE NOISE AND COMPRESSION CHARACTERISTICS**

(71) Applicant: SDRF EURL, 06410 Biot (Sophia Antipolis) (FR)
(72) Inventor: Bisanti, Biagio, 06600 Antibes (FR); Duvivier, Eric, 06220 Vallauris Golfe Juan (FR); Carpineto, Lorenzo, 06600 Antibes (FR); Cipriani, Stefano, 06600 Antibes (FR); Coppola, Francesco, 06130 Grasse (FR); Puccio, Gianni, 06610 La Gaude (FR); Artinian, Rémi, 06600 Antibes (FR); Marot, Francois, 06600 Antibes (FR); Bodrero, Vanessa, 06140 Vence (FR); Koechlin, Lysiane, 06220 Vallauris (FR)
(74) Representative: Schuffenecker, Thierry

(57) **Abstract**

A variable gain amplifier (VGA) comprising an input terminal (11) for receiving an input signal, an output terminal (22) for generating an amplified signal in accordance with a control voltage (Vc) applied to a control terminal (101, 201), characterized in that it includes:
- a first stage comprising:
- a first variable amplifier (10) having an input connected to said input terminal (11) and an output (12),
- a first control block (100) having an input receiving said control voltage (Vc) for controlling the gain of said first amplifier (10), said first control block (100) comprising a first register (110) being configured for storing a first control word (CW1) dedicated for determining the point of action of said first amplifier (10);

- a second stage comprising:
- a second variable amplifier (20) having an input connected to the output of said first amplifier (10) and having an output (22) for generating said amplified signal,
- a second control block (200) having an input receiving said control voltage (Vc) for controlling the gain of said second amplifier (20), said second control block (200) comprising a second register (110) being configured for storing a second control word (CW1) dedicated for determining the point of action of said second amplifier (10);

whereby the point of action of said first and said second amplifiers (10, 20) can be independently set.

## Description

### Technical field

The invention relates to the field of electronic circuits and more particularly to a variable Gain Amplifier (VGA) which has programmable noise and compression characteristics.

### Background Art

Variable gain amplifiers (VGA) or voltage-controlled amplifiers are electronic amplifiers having a gain being controllable in accordance to a control voltage. Those circuits are quite useful in the design of many electronics devices and have many applications, including audio level compression, synthesizers and amplitude modulation.

Conventional VGAs may be analog controlled amplifiers having a gain defined by an analog control voltage or may also be digitally controlled amplifier having a gain defined by the contents of a control register.

The control voltage, or the digital information controlling the gain of the VGA results from an evaluation of the power of a signal being input into a system (e.g. a RF receiver) and consequently the amount of gain required in order to maintain a relative constant output signal, regardless of the signal's variations at the input of the system..

Generally speaking, variable gain amplifiers (VGA) are designed so as to provide the best immunity to the noise (particularly when input signals of very low amplitude are to be processed) or, alternatively, to provide the best response in terms of compression, when input signals are assumed to show higher voltage variations.

With the consequence that the design of a variable gain amplifier (VGA) is performed by taking into account the specific application being considered by the designer.

However, there is a need for a variable gain amplifier offering programmable response regarding both noise and compression.

This is the technical problem to be solved by the present invention.

### Summary of the invention

It is an object of the present invention to provide a variable gain amplifier (VGA) which allows to precisely set the characteristics of the VGA with respect to the noise and/or compression.

It is a further object of the present invention to provide a variable gain amplifier (VGA) which provides digital control of the best strategy with regard to the noise and/or compression.

It is still another object of the present invention to provide a variable gain amplifier (VGA) which provides a high level of flexibility with regard to noise and compression characteristics.

These and other objects of the invention are achieved by means of a variable gain amplifier (VGA) comprising an input terminal for receiving an input signal, an output terminal for generating an amplified signal in accordance with a control voltage (Vc) applied to a control terminal.

The VGA is characterized in that it comprises a first stage comprising:
- a first variable amplifier having an input and an output,
- a first control block having an input receiving the control voltage (Vc) for controlling the gain of the first amplifier (10), with the first control block comprising a first register being configured for storing a first control word (CW1) dedicated for determining the point of action of the amplifier (10);

The VGA further comprises a second stage comprising:
- a second variable amplifier connected in cascade downwards the first amplifier,
- a second control block having an input receiving the control voltage (Vc) for controlling the gain of the second amplifier (20) and further comprising a second register being configured for storing a second control word (CW1) dedicated for determining the point of action of the second amplifier (10).

The invention allows the independent setting of the two values CW1 and CW2 so as to independently set of the point of action of the two amplifiers.

Preferably, the first control word carries a value CW1 which corresponds to a first threshold voltage Vc1 and the first control block associated to the first amplifier is configured to control the latter so as to start decreasing its gain when the control voltage Vc is higher than the value of the first threshold value Vc1.

Also, the second control word carries a value CW2 which corresponds to a second threshold voltage Vc2, and the second control block is configured to control the second amplifier so as to start decreasing its gain when the control voltage Vc is higher than the second threshold value Vc2.

In one embodiment, the first and second amplifiers are single ended amplifiers.

Alternatively, the two amplifiers can be differential amplifiers.

Preferably, the first amplifier is configured to be a low noise amplifier (LNA).

The invention also achieves a process for reducing the gain of a variable gain amplifier (VGA) comprising an input terminal for receiving an input signal to be amplified and an output terminal for generating an amplified signal in accordance with a control voltage (Vc) applied to a control terminal.

The process includes the steps of:
- providing a first stage comprising:
   - a first variable amplifier having an input connected to the input terminal and an output,
   - a first control block having an input receiving said control voltage (Vc) for controlling the gain of the first amplifier, the first control block comprising a first register being configured for storing a first control word (CW1) dedicated for determining the point of action of the first amplifier ;
- providing a second stage comprising:
   - a second variable amplifier having an input connected to the output of the first amplifier and having an output for generating the amplified signal,
   - a second control block having an input receiving the control voltage (Vc) for controlling the gain of the second amplifier, the second control block comprising a second register being configured for storing a second control word (CW2) dedicated for determining the point of action of the second amplifier;
- storing control values (CW1, CW2) into the first and said second registers so as to independently set the point of actions of the two amplifiers.

In one embodiment, the process is such that the first control word carries a value CW1 which corresponds to a first threshold voltage Vc1 and the first control block is configured to control first amplifier 10 so as to start decreasing the gain of the first amplifier when said control voltage Vc is higher than the value of the first threshold value Vc1.

In one embodiment, the process is such that the second control word carries a value CW2 which corresponds to a second threshold voltage Vc2, and that the process involves the configuration of the second amplifier (20) so as to start decreasing its gain when the control voltage Vc is higher than the value of the second threshold value Vc2.

The invention is particularly adapted to achieve a flexible variable gain amplifier which allows digital software control.

### Description of the drawings

Other features of one or more embodiments of the invention will appear from the following description of embodiments of the invention, with reference being made to the accompanying drawings.
Figure 1 illustrates a first embodiment of a variable gain amplifier which is based on a two-stage circuit.
Figure 2 illustrates a second embodiment of a variable gain amplifier which is based on a three-stage circuits.

### Description of the preferred embodiment

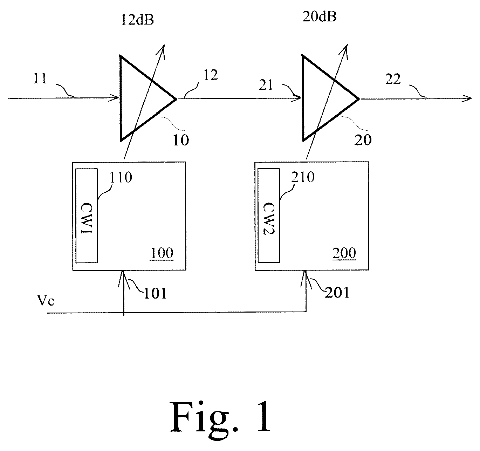

With respect to figure 1, there will now be described a first embodiment of a variable gain amplifier (VGA) which is based on a cascade of two amplifiers, respectively 10 and 20. Amplifiers 10 and 20 may be single end amplifiers or differential amplifiers in accordance to the particular application being considered. In the architecture shown in figure 1, amplifier 10 may be a single end low noise amplifier (LNA) which has an input terminal 11 which receives an input signal and an output terminal 12. Amplifier 10 is further associated to a first control block 100 which has an input 101 for receiving a control voltage Vc for controlling the gain of amplifier 10. First control block 100 further includes a first register 110 which is configured for storing a first control word (CW1) dedicated for determining the point of action of first amplifier, and more precisely a first threshold value Vc1. In accordance with the value carried by CW1, control block 100 controls first amplifier 10 so as to start decreasing the gain of amplifier 10 when the control voltage Vc is higher than the value of first threshold value Vc1.

In addition to amplifier 10, the first embodiment further includes a second amplifier 20 which, again, may be a single ended or differential amplifier. In the figure, amplifier 20 is represented as an single ended amplifier having a input terminal 21 which is connected to the output terminal 12 of amplifier 10. Amplifier 20 is further associated to a second control block 200 which has an input 201 also receiving control voltage Vc for controlling the gain of amplifier 20. Second control block 200 further includes a second register 210 which is configured for storing a second control word (CW2) used for determining the point of action of second amplifier 20, and more precisely a second threshold value Vc2 determining a point of action of amplifier 20. Similarly as above, in accordance with the value CW2 stored within the second register 210, control block 200 controls second amplifier 20 so as to start decreasing the gain of amplifier 20 when the control voltage Vc is higher than the value of second threshold value Vc2.

Therefore, the setting of the two control values CW1 and CW2, respectively, permits the variable gain amplifier - comprising the cascade of amplifiers 10 and 20 - to apply a determined profile of action which may be used for applying one particular strategy with regard to the noise and/or compression.

Assuming, for instance, that amplifiers 10 and 20 have respectively a gain of 12dB and 20dB, thus resulting in an overall gain of 32 dB for the amplifying cascade, which can be controlled by the analog voltage Vc applied at inputs 101 and 201 of control blocks 100 and 200.

The control of the overall gain of the amplifying cascade will be however different in accordance with the particular values CW1 and CW2 being respectively stored within registers 110 and 210.

With the consequence of a different overall action of the cascade of amplifiers with regard to noise and/or compression. This arrangement allows the control of the behavior of the variable gain amplifier composed of the cascade of amplifiers 10/20.

Thanks to the digital control of control blocks 100 and 200, the overall action of the variable gain amplifier can be precisely set by means of software program or even directly by a user.

For instance, if the user/software stores a value CW1 which corresponds to a very low threshold value Vc1, and further stores into register 210 a value CW2 that corresponds to a higher value of threshold value Vc2, this will entail that amplifier 10 will start reducing its gain well before amplifier 20 reduces its own gain. Second amplifier 20 will start reducing its own gain only when the input voltage reaches the value of second threshold Vc2, with the consequence that the overall amplifying cascade will appear as a variable gain amplifier showing very good performance with respect to the noise since the first amplifier 10 only starts to reduce its gain at higher voltage value of the input signal.

Conversely, if the user/software sets the values CW1 and CW2 so as to causes first amplifier 10 to start reducing its gain first, then one sees that the amplifying cascade shows better performance when the input signal shows some waveforms of higher magnitude, thus avoiding any possible overloading of the first stage. Therefore, in that configuration, the overall amplifying cascade shows a better behavior with regard to compression (input signals with possibly high level) but a lower performance with regard to the noise because of the reduction of gain of the first stage which starts first to reduce its gain while the second amplifier 20 maintains its own gain.

If the two situations described above shows a similar overall gain value (32dB varying with the control voltage Vc), the behavior of the cascade shows to be quite different with regard to the noise and/or the compression (or the combination of both).

Generally speaking, control voltage Vc is generated by any feedback network which might be arranged for the purpose of controlling both first and second control blocks 100 and 200, for instance a feedback network including a peak detector (not shown in the figure) for the purpose of estimating the power of the received input signal presented at terminal 11.

However, it is clear that the embodiment which was described may be applied to any kind of feedback network.

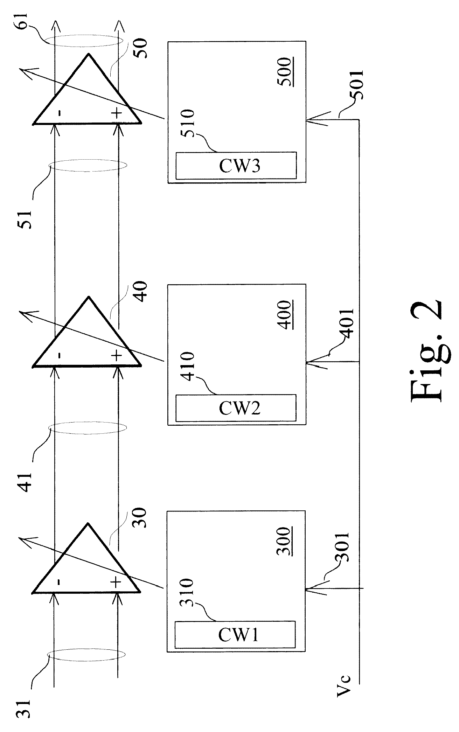

With respect to figure 2, there will now be described as second embodiment which is based on a cascade of three individual amplifiers being, for the sake of illustrations, differential amplifiers 30, 40 and 50.

Differential amplifier 30 has two input terminals 31 receiving a different input signal and further has two output terminals 41. Amplifier 30 is associated to a first control block 300 which has an input 301 for receiving control voltage Vc for controlling the gain of amplifier 30. First control block 300 further includes a first register 310 for the purpose of storing a first control word (CW1) dedicated for determining the point of action of amplifier 300, and more precisely a first threshold value Vc1. As previously, for the two-stage arrangement, control block 300 controls first amplifier 30 of figure 2 so as to start decreasing its gain when the control voltage Vc is higher than Vc1.

The second embodiment of figure 2 further includes a second differential amplifier 40 which has two inputs connected to the output 41 of the first stage 30. Amplifier 40 is further associated to a second control block 400 which input receive the control voltage Vc for controlling the gain of amplifier 40. Second control block 400 further includes a second register 410 which is configured for storing a second control word (CW2) used for determining the point of action of second amplifier 40, and more precisely a second threshold value Vc2 determining a point of action of that different amplifier 20. As above, in accordance with the value CW2 stored within the second register 410, control block 400 controls second differential amplifier 40 so as to start decreasing its gain when the control voltage Vc is higher than Vc2.

At last, the second embodiment includes a third differential amplifier 50 which has two input terminals 51 connected to the outputs of the second stage amplifier 40. Amplifier 50 has two outputs connected to the output 61 of the variable gain amplifier for generating the amplified signal. Amplifier 50 is further associated to a third control block 500 which has an input 501 receiving control voltage Vc for controlling the gain of amplifier 50. Third control block 500 further includes a third register 510 which is configured for storing a third control word (CW3) used for determining the point of action of third amplifier 50, and more precisely a third threshold value Vc3. As above, control block 500 controls third amplifier 50 so as to start decreasing the gain of amplifier 50 when the control voltage Vc is higher than the value of third threshold value Vc3.

It can be seen that the second embodiment of the variable gain amplifier provides more flexibility with respect to the possible configurations (determined by the values of CW1, CW2, CW3) for combining an appropriate action of the cascade of three amplifiers with respect to noise and also to compression.

It should be clear that the invention should not be limited to three amplifiers and that a greater number of stages may be used, when appropriate.

## Claims

1. A variable gain amplifier (VGA) comprising an input terminal (11) for receiving an input signal to be amplified and an output terminal (22) for generating an amplified signal in accordance with a control voltage (Vc) applied to a control terminal (101, 201), **characterized in that** it includes:
- a first stage comprising:
- a first variable amplifier (10) having an input connected to said input terminal (11) and an output (12),
- a first control block (100) having an input receiving said control voltage (Vc) for controlling the gain of said first amplifier (10), said first control block (100) comprising a first register (110) being configured for storing a first control word (CW1) dedicated for determining the point of action of said first amplifier (10);
- a second stage comprising:
- a second variable amplifier (20) having an input connected to the output of said first amplifier (10) and having an output (22) for generating said amplified signal,
- a second control block (200) having an input receiving said control voltage (Vc) for controlling the gain of said second amplifier (20), said second control block (200) comprising a second register (210) being configured for storing a second control word (CW2) dedicated for determining the point of action of said second amplifier (20);
whereby the point of action of said first and said second amplifiers (10, 20) can be independently set.

2. The variable gain amplifier (VGA) according to claim 1 **characterized in that** said first control word carries a value CW1 which corresponds to a first threshold voltage Vc1, and that said first control block (100) is configured to control first amplifier 10 so as to start decreasing the gain of said first amplifier (10) when said control voltage Vc is higher than the value of said first threshold value Vc1.

3. The variable gain amplifier (VGA) according to claim 2 **characterized in that** said second control word carries a value CW2 which corresponds to a second threshold voltage Vc2, and that said second control block (200) is configured to control second amplifier (20à so as to start decreasing the gain of said second amplifier (20) when said control voltage Vc is higher than the value of said second threshold value Vc2.

4. The variable gain amplifier (VGA) according to claim 1 **characterized in that** said amplifiers are single ended amplifiers.

5. The variable gain amplifier (VGA) according to claim 1 **characterized in that** said amplifiers are differential amplifiers.

6. The variable gain amplifier (VGA) according to claim 1 **characterized in that** said first amplifier (10) is a low noise amplifier (LNA).

7. The variable gain amplifier (VGA) according to claim 1 **characterized in that** said it comprises more than two stages of amplifiers.

8. A process for reducing the gain of a variable gain amplifier (VGA) comprising an input terminal (11) for receiving an input signal to be amplified and an output terminal (22) for generating an amplified signal in accordance with a control voltage (Vc) applied to a control terminal (101, 201), **characterized in that** it includes the steps of :
- providing a first stage comprising:
- a first variable amplifier (10) having an input connected to said input terminal (11) and an output (12),
- a first control block (100) having an input receiving said control voltage (Vc) for controlling the gain of said first amplifier (10), said first control block (100) comprising a first register (110) being configured for storing a first control word (CW1) dedicated for determining the point of action of said first amplifier (10);
- providing a second stage comprising:
- a second variable amplifier (20) having an input connected to the output of said first amplifier (10) and having an output (22) for generating said amplified signal,
- a second control block (200) having an input receiving said control voltage (Vc) for controlling the gain of said second amplifier (20), said second control block (200) comprising a second register (210) being configured for storing a second control word (CW2) dedicated for determining the point of action of said second amplifier (20);
- storing control values (CW1, CW2) into said first and said second registers so as to independently set the point of actions of said amplifiers (10, 20).

9. The process of claim 8, wherein said first control word carries a value CW1 which corresponds to a first threshold voltage Vc1, and that said first control block (100) is configured to control first amplifier 10 so as to start decreasing the gain of said first amplifier (10) when said control voltage Vc is higher than the value of said first threshold value Vc1.

10. The process of claim 9 wherein said second control word carries a value CW2 which corresponds to a second threshold voltage Vc2, and that said second control block (200) is configured to control second amplifier (20à so as to start decreasing the gain of said second amplifier (20) when said control voltage Vc is higher than the value of said second threshold value Vc2.

11. The process of anyone of claims 8 to 10 wherein said first and second amplifiers (10, 20) are single ended amplifiers.

12. The process of anyone of claims 8 to 10 wherein said first and second amplifiers (10, 20) are differential amplifiers.

13. The process of anyone of claims 8 to 12 wherein the values of said first and second control words (CW1, CW2) are digitally controlled by software.
